(19) **Europäisches Patentamt European Patent Office Office européen des brevets**

(11) **EP 4 761 106 A1**

(12) **EUROPEAN PATENT APPLICATION**

(43) Date of publication:
**17.06.2026 Bulletin 2026/25**

(21) Application number: **25207992.6**

(22) Date of filing: **10.10.2025**

(51) International Patent Classification (IPC):
**H03F 3/193** (2006.01)   **H03F 3/45** (2006.01)
**H03F 3/68** (2006.01)

(52) Cooperative Patent Classification (CPC):
**H03F 3/193; H03F 3/45475; H03F 3/68;**
H03F 2200/111; H03F 2200/294; H03F 2200/451

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **13.12.2024 US 202418979656**

(71) Applicant: **Intel Corporation**
**Santa Clara, CA 95054 (US)**

(72) Inventors:
• **DEGANI, Ofir**
  **22801 Nes-Ammin (IL)**
• **GROSGLIK, Uri**
  **4060000 Tel Mond (IL)**
• **GUPTA, Soumya**
  **Corvallis, 97330 (US)**
• **KRISHNAMURTHY, Sashank**
  **Hillsboro, 97124 (US)**
• **RAVI, Ashoke**
  **Portland, 97219 (US)**

(74) Representative: **Viering, Jentschura & Partner mbB**
**Patent- und Rechtsanwälte**
**Am Brauhaus 8**
**01099 Dresden (DE)**

(54) **VOLTAGE-MODE AMPLIFIER**

(57)  A voltage-mode amplifier, comprising a first filter stage, comprising: a first voltage amplifier, connected to an input trace, and configured to amplify a signal conducted along the input trace; and a first N-path filter, connected to the input trace; wherein the first N-path filter is configured to shunt to a first reference voltage frequency from the signal; and a second filter stage, connected to the input trace in parallel to the first filter stage, comprising: a second voltage amplifier, connected to the input trace, and configured to amplify the signal conducted along the input trace; and a second N-path filter, connected to the input trace; and wherein the second N-path filter is configured to shunt to a second reference voltage frequency from the signal.

FIG. 3

EP 4 761 106 A1

## Description

### Background

Given the need to support higher over-the-air throughputs and the emergence of use cases requiring parallel, low-latency connections to multiple devices (e.g., to an access point, to a peer-peer device), connectivity protocols are evolving to require multiple radio links to be operated simultaneously on the same platform. Starting from multiple-input multiple-output (MIMO) communications, spatial multiplexing current standards have added concurrent dual-band (CDB) and triple-band dual concurrency (TBDC) protocols, and future releases will require support for finer grained carrier aggregation and multiprotocol modes.

Efforts to meet these requirements by extending the conventional radio architecture to multiple transceivers, each tuned to a different frequency band, with off-chip components like filters, switches and duplexers to interface with common antennas results in increased cost and complexity. Another approach is to aggregate multiple tuned low noise amplifiers (LNAs) into a single wideband amplifier topology with embedded channel selectivity, which may permit multiband operation with reduced die area and component count. Operating multiple links asynchronously in the same frequency bands, however, means that the platform can have scenarios where a high power transmission (TX) is in close spatial and frequency proximity to a reception (RX) with only limited isolation (e.g., 15-25dB). This TX can thus act as a self-interferer and needs to be handled without compression until it is suppressed by the N-path based channel filter in the LNA.

### Brief Description of the Drawings

In the drawings, like reference characters generally refer to the same parts throughout the different views. The drawings are not necessarily to scale, emphasis instead generally being placed upon illustrating the exemplary principles related to the embodiments disclosed herein. In the following, exemplary embodiments are described with reference to the following drawings, in which:

FIG. 1 depicts an LNA with a 2-stage input-matched broadband transconductance stage;
FIG. 2 depicts an alternative solution to address the trade-off of contrasting requirements for transconductance by introducing a resistor;
FIG. 3 depicts a voltage-mode implementation of the staggered 2-frequency N-path solution depicted in FIG. 2;
FIG. 4 depicts curves indicating the noise figure penalty due to the combination of 2-frequency N-path filter responses in current mode;
FIG. 5 depicts the noise figure penalty for the transfer functions for a staggered-voltage-mode 2-frequency N-path filter;
FIG. 6A depicts an amplification stage with N-path filter as depicted in FIG. 3 according to a first aspect;
FIG. 6B depicts an amplification stage with N-path filter according to a second aspect;
FIG. 7 depicts a simulation of the two N-path filters shown in FIGs. 6A and 6B;
FIG. 8 depicts a circuit according to the second aspect;
FIG. 9 depicts certain benefits of the circuit of FIG. 8 as compared to the circuit of FIG. 3;
FIG. 10 depicts a voltage-mode amplifier; and
FIG. 11 depicts a method of voltage amplification.

### Description

The following detailed description refers to the accompanying drawings that show, by way of illustration, exemplary details and embodiments in which aspects of the present disclosure may be practiced.

The word "exemplary" is used herein to mean "serving as an example, instance, or illustration". Any embodiment or design described herein as "exemplary" is not necessarily to be construed as preferred or advantageous over other embodiments or designs.

Throughout the drawings, it should be noted that like reference numbers are used to depict the same or similar elements, features, and structures, unless otherwise noted.

The phrase "at least one" and "one or more" may be understood to include a numerical quantity greater than or equal to one (e.g., one, two, three, four, [...], etc.). The phrase "at least one of" with regard to a group of elements may be used herein to mean at least one element from the group consisting of the elements. For example, the phrase "at least one of" with regard to a group of elements may be used herein to mean a selection of: one of the listed elements, a plurality of one of the listed elements, a plurality of individual listed elements, or a plurality of a multiple of individual listed elements.

The words "plural" and "multiple" in the description and in the claims expressly refer to a quantity greater than one. Accordingly, any phrases explicitly invoking the aforementioned words (e.g., "plural [elements]", "multiple [elements]") referring to a quantity of elements expressly refers to more than one of the said elements. For instance, the phrase "a plurality" may be understood to include a numerical quantity greater than or equal to two (e.g., two, three, four, five, [...], etc.).

The phrases "group (of)", "set (of)", "collection (of)", "series (of)", "sequence (of)", "grouping (of)", etc., in the description and in the claims, if any, refer to a quantity equal to or greater than one, i.e., one or more. The terms "proper subset", "reduced subset", and "lesser subset" refer to a subset of a set that is not equal to the set, illustratively, referring to a subset of a set that contains less elements than the set.

The term "data" as used herein may be understood to include information in any suitable analog or digital form, e.g., provided as a file, a portion of a file, a set of files, a signal or stream, a portion of a signal or stream, a set of signals or streams, and the like. Further, the term "data" may also be used to mean a reference to information, e.g., in form of a pointer. The term "data", however, is not limited to the aforementioned examples and may take various forms and represent any information as understood in the art.

The terms "processor" or "controller" as, for example, used herein may be understood as any kind of technological entity that allows handling of data. The data may be handled according to one or more specific functions executed by the processor or controller. Further, a processor or controller as used herein may be understood as any kind of circuit, e.g., any kind of analog or digital circuit. A processor or a controller may thus be or include an analog circuit, digital circuit, mixed-signal circuit, logic circuit, processor, microprocessor, central processing unit (CPU), graphics processing unit (GPU), digital signal processor (DSP), field programmable gate array (FPGA), integrated circuit, application specific integrated circuit (ASIC), etc., or any combination thereof. Any other kind of implementation of the respective functions, which will be described below in further detail, may also be understood as a processor, controller, or logic circuit. It is understood that any two (or more) of the processors, controllers, or logic circuits detailed herein may be realized as a single entity with equivalent functionality or the like, and conversely that any single processor, controller, or logic circuit detailed herein may be realized as two (or more) separate entities with equivalent functionality or the like.

As used herein, "memory" is understood as a computer-readable medium (e.g., a non-transitory computer-readable medium) in which data or information can be stored for retrieval. References to "memory" included herein may thus be understood as referring to volatile or non-volatile memory, including random access memory (RAM), read-only memory (ROM), flash memory, solid-state storage, magnetic tape, hard disk drive, optical drive, 3D XPointTM, among others, or any combination thereof. Registers, shift registers, processor registers, data buffers, among others, are also embraced herein by the term memory. The term "software" refers to any type of executable instruction, including firmware.

Unless explicitly specified, the term "transmit" encompasses both direct (point-to-point) and indirect transmission (via one or more intermediary points). Similarly, the term "receive" encompasses both direct and indirect reception. Furthermore, the terms "transmit," "receive," "communicate," and other similar terms encompass both physical transmission (e.g., the transmission of radio signals) and logical transmission (e.g., the transmission of digital data over a logical software-level connection). For example, a processor or controller may transmit or receive data over a software-level connection with another processor or controller in the form of radio signals, where the physical transmission and reception is handled by radio-layer components such as radiofrequency (RF) transceivers and antennas, and the logical transmission and reception over the software-level connection is performed by the processors or controllers. The term "communicate" encompasses one or both of transmitting and receiving, i.e., unidirectional or bidirectional communication in one or both of the incoming and outgoing directions. The term "calculate" encompasses both 'direct' calculations via a mathematical expression/formula/relationship and 'indirect' calculations via lookup or hash tables and other array indexing or searching operations.

Prior efforts to remedy the interference from nearby feeds and/or nearby frequencies, as described above, have included: extending the conventional radio architecture to multiple transceivers, wherein each transceiver is tuned to a different frequency band, with off-chip components like filters, switches and duplexers to interface to the common antennas imposes prohibitive cost and complexity penalties on the platform; using resistive feedback wideband LNAs, which, however, have little to no selectivity and suffer from compression due to strong blockers; channel selective wideband mixer topologies, which, however, suffer from very high noise figures; and LNAs with current-summation-based staggered N-path filters, which, however, suffer from higher noise figure, high insertion loss, and non-linearity.

In the following, and according to a first aspect, an adaptive high-linearity LNA front-end can suppress undesired frequencies (e.g., frequencies from a nearby, non-isolated or low-isolation feed) using an N-path based, volume-mode channel filter in the LNA. This wideband channel selective LNA front-end circuit can achieve good noise performance and high linearity in the presence of a self-transmission blocker. This may be achieved by embedding a voltage-mode staggered 2-frequency N-path filter at the output of a broadband voltage amplifier; and subtracting the responses of the staggered 2-frequency N-path filters after passing them through voltage gain. This mitigates the various trade-offs involved in a current-mode implementation, as described above.

The topology improves the linearity, and hence, the blocker tolerance of the input stage of a wideband channel selective LNA while maintaining a competitive noise figure relative to tuned LNAs. The blocker can be handled up to the shunt N-path filter stage, where it is filtered out without compressing the front-end. This eliminates the cost and complexity of external bulk acoustic wave filters or surface acoustic wave filters while also improving system key performance indicators (KPIs), such as with respect to the noise figure and power dissipation, by eliminating the loss of those external filters.

A wideband channel selective LNA should exhibit (a) wideband operation, (b) low noise and high linearity, (c) high channel-selectivity, and (d) low area. The LNA as described herein achieves these objectives by using a wideband inverter stage that drives a multi-frequency staggered N-path-filter based channel-selective amplifier.

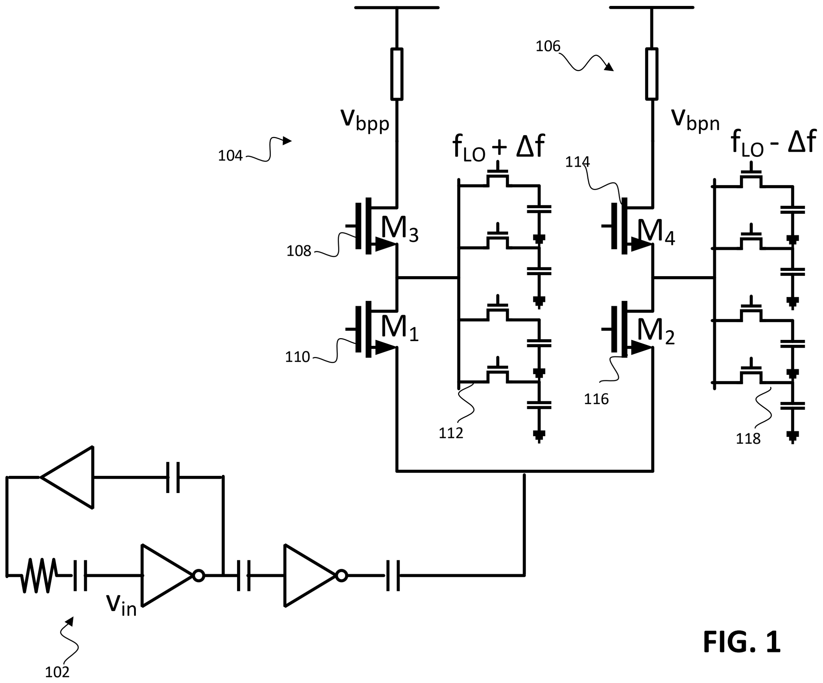

FIG. 1 depicts an LNA with a 2-stage input-matched broadband transconductance stage. Transconductance, which may also be known as mutual conductance, describes current at the output of a device relative to the voltage at the input of the device, and may be abbreviated as $g_m$, and generally understood as $g_m = (\Delta I_{out})/(\Delta V_{in})$. The LNA includes a first signal amplifier, which may be referred to as an input stage 102, a first differential amplification stage 104 and a second differential amplification stage 106. The transconductance stage drives a 2-stage cascode stack. That is, the first differential amplification stage 104 includes a first cascode transistor 108, a second cascode transistor 110, and an the first N-path filter 112 configured in a shunt configuration relative to the cascode transistors of the first differential amplification stage 104. The second differential amplification stage 106 includes a first cascode transistor 114, a second cascode transistor 116, and the second N-path filter 118 configured in a shunt configuration relative to the cascode transistors of the second differential amplification stage 106. Channel selectivity is achieved by using staggered n-path filters (the first N-path filter 112 and the second N-path filter 118) at two different frequencies at the drain of the first cascode of the relevant differential amplification stage. The noise of the second cascode M3/M4 (108, 114) may be minimized only by having a skewed relative transconductance between the second cascode M3/M4 (108, 114) and the first cascode M1/M2 (110, 116), with $g_{m3,4} << g_{m1,2}$, wherein $g_m$ is the transconductance (the m referring to the mutual conductance), which may be understood as $g_m = \dfrac{\partial I_D}{\partial V_{GS}}$ (for field effect transistors) and $g_m = \dfrac{\partial I_C}{\partial V_{BE}}$ for bipolar transistors, wherein

$I_D$ is the DC drain current, $G_S$ is the gate-source voltage, $I_C$ is the DC collector current, and $V_{BE}$ is the base-emitter voltage.

This constraint also minimizes the insertion loss due to combining the responses of the two staggered N-path filters. A high transconductance $g_{m1,2}$ is required for the first stage cascode devices for linear current mode summation. It would be possible to resolve the contrasting requirements of $g_{m1,2}$ versus $g_{m3,4}$ with a regulated cascode to boost the $g_{m1,2}$ of the first stage cascode device. However, this solution comes at the cost of linearity, since the feedback amplifiers used to boost $g_{m1,2}$ in the regulated cascode suffer from compression in the presence of a blocker. Additionally, there is also a power penalty for implementing the feedback amplifiers.

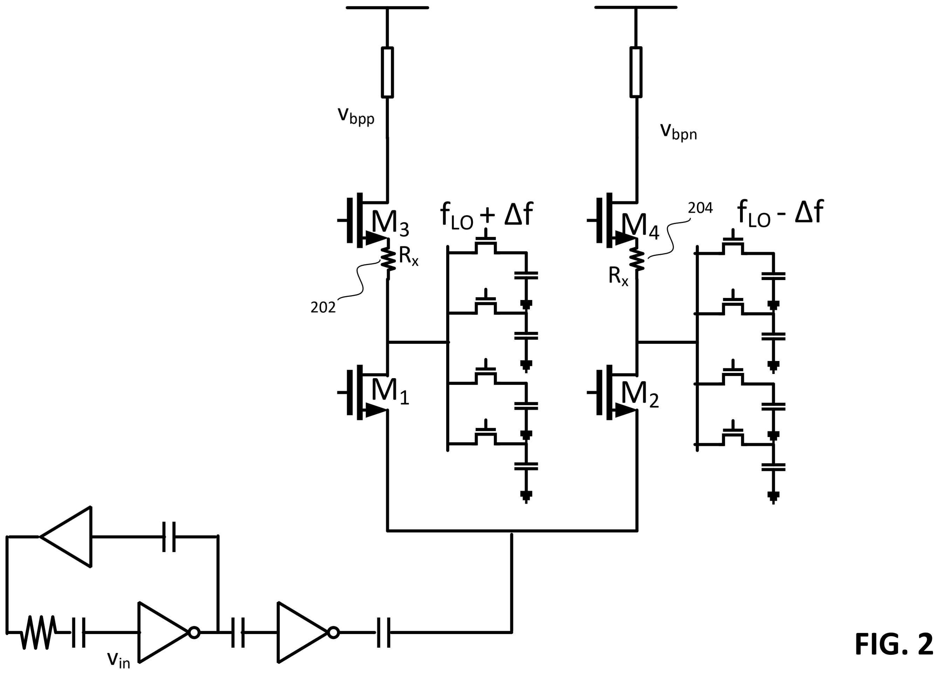

FIG. 2 depicts an alternative solution to address the trade-off of contrasting requirements for $g_{m1,2}$ versus $g_{m3,4}$ by introducing a resistor $R_X$ 202, 204 in series at the source of the second stage cascode transistors M3,4. For simplicity, and as the remaining elements of FIG. 2 are identical to those of FIG. 1, these will not be renumbered herein. The earlier constraint of $1/g_{m3,4} >> 1/g_{m1,2}$ now translates to $(1/g_{m3,4}+R_x)>>1/g_{m1,2}$ thereby relaxing the asymmetrical requirements of the first and second stage cascode devices. While this strategy can help reduce amplifier feedback needed to boost $g_{m1,2}$, the addition of the $R_x$ significantly increases the supply voltage needed for this strategy to work. As it may be undesirable in certain circumstances to significantly increase the supply voltage, a further alternative is explored.

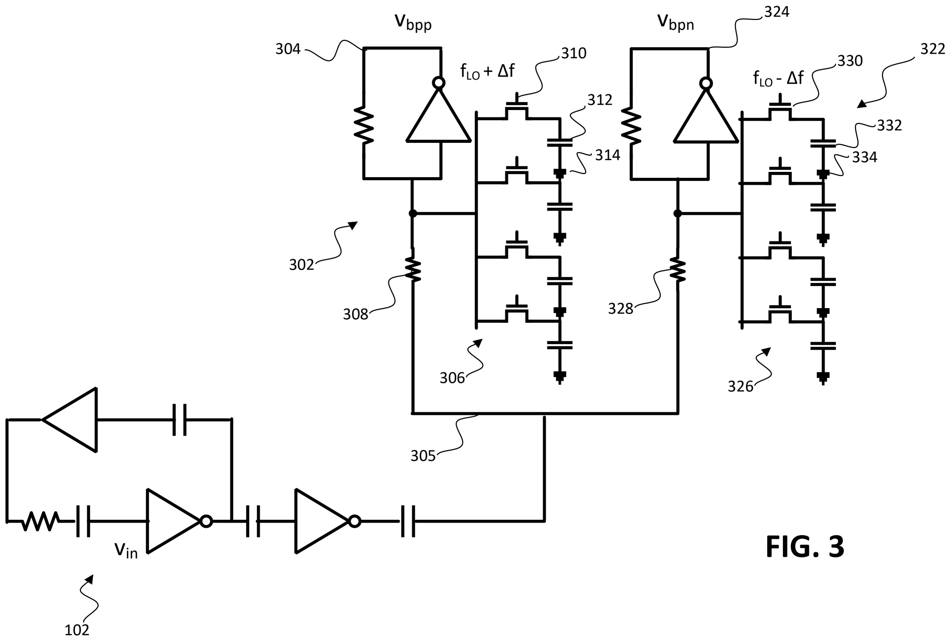

In the circuits of FIGs. 1 and 2, the staggered N-path solution is implemented in the current mode, wherein the input transconductance is current-buffered through a 2-stage cascode. For low insertion loss and noise figure, either the second-stage $g_{m3,4}$ must be very small (e.g., as in FIG. 1) or the series resistance Rx must be very large (e.g., as in FIG. 2), either of which may lead to undesired outcomes. To counteract this potential for undesired outcomes, FIG. 3 depicts a voltage-mode implementation of the staggered 2-frequency N-path solution depicted in FIG. 2. FIG. 3 depicts a voltage-mode amplifier that includes the input stage 102. FIG. 3 further includes a first filter stage 302 that itself includes a first voltage amplifier 304, connected to an input trace 305, and configured to amplify a signal conducted along the input trace 305. The first filter stage 302 further includes a first N-path filter 306, which is connected to the input trace 305, wherein the first N-path filter 306 is configured to shunt to a first reference voltage frequency from the signal. The first filter stage 302 may also include a first ohmic resistor 308, along the input trace 305 as it connects to the first voltage amplifier 304. Otherwise stated, the first ohmic resistor 308 may be between the first voltage amplifier 304 and a junction where the output of the input stage 102 splits to continue toward each of the first filter stage 302 and a second filter stage 322.

The first N-path filter 306 may include a plurality of filter paths, each filter path including a transistor 310, a capacitor 312, and a reference voltage 314. The first N-path filter 306 may be configured to cause its transistors to become conductive a non-conductive (e.g., in switch terms, to close and open the switch) in succession such that a first portion of a signal conducts through a first transistor of the N-path filter and charges a first capacitor, a second portion of the signal conducts through the second transistor of the N-path filter and charges the second capacitor, and so on. Using the principles by which N-path filters operate, the frequency or frequencies to be filtered can be selected based on the frequency used to control the transistors within the N-path filter.

The voltage-mode amplifier includes the second filter stage 322 connected to the input trace 305 in parallel to the first filter stage 302. The second filter stage 322 includes a second voltage amplifier 324, connected to the input trace 305, and configured to amplify the signal conducted along the input trace, and a second N-path filter 326, connected to the input trace 305, The second N-path filter 326 may be configured to shunt to a second reference voltage frequency from the signal.

The second filter stage 322 may also include a second ohmic resistor 328, along the input trace 305 as it connects to the second voltage amplifier 324. Otherwise stated, the second ohmic resistor 328 may be between the second voltage amplifier 324 and a junction where the output of the input stage 102 splits to continue toward each of the first filter stage 302 and the second filter stage 322.

The second N-path filter 326 may include a plurality of filter paths, each filter path including a transistor 330, a capacitor 332, and a reference voltage 334. The second N-path filter 326 may be configured to cause its transistors to become conductive a non-conductive (e.g., in switch terms, to close and open the switch) in succession such that a first portion of a signal conducts through a first transistor of the N-path filter and charges a first capacitor, a second portion of the signal conducts through the second transistor of the N-path filter and charges the second capacitor, and so on. Using the principles by which N-path filters operate, the frequency or frequencies to be filtered can be selected based on the frequency used to control the transistors within the N-path filter.

In this manner, the input stage includes the first voltage amplifier 304. The output voltage of this amplifier is then fed to the two staggered N-path filters (the first N-path filter 306 and the second N-path filter 326), which are operated at two frequencies. The two N-path filters are separated by a the first ohmic resistor 308 and the second ohmic resistor 328, which provides isolation and reduces interaction of the individual N-path responses. While such a solution of isolation by a resistor would degrade the noise figure in a mixer-first approach, the input stage 102 (e.g., the voltage amplifier preceding the staggered N-path filters) mitigates this effect. The first filter stage 302 and the second filter stage 322 (e.g., the two nodes), which are bandpass filtered by the first N-path filter 306 and the second N-path filter 326, drive inverter-based amplifiers (e.g., the first voltage amplifier 304 and the second voltage amplifier 324). The differential output of the two inverter-based amplifiers yields a second-order bandpass response with sufficient voltage gain. Such a solution overcomes the noise/insertion loss trade-offs in the current-mode implementations of FIGs. 1 and 2 with a 2-stage cascode structure.

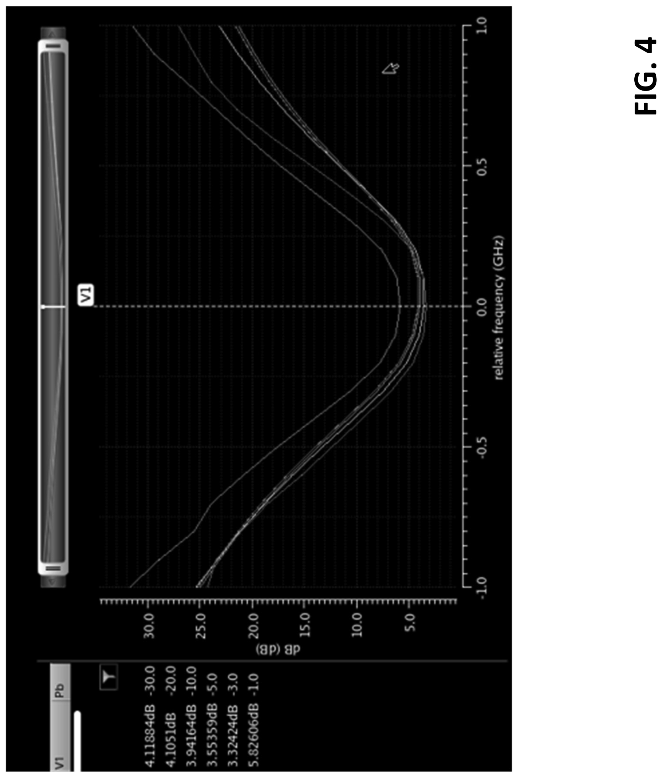

FIG. 4 depicts curves indicating the noise figure penalty due to the combination of 2-frequency N-path filter responses in current mode. That is, FIG. 4 depicts a family of noise figure plots for a wideband LNA with current-mode-staggered 2-frequency N-path filter.

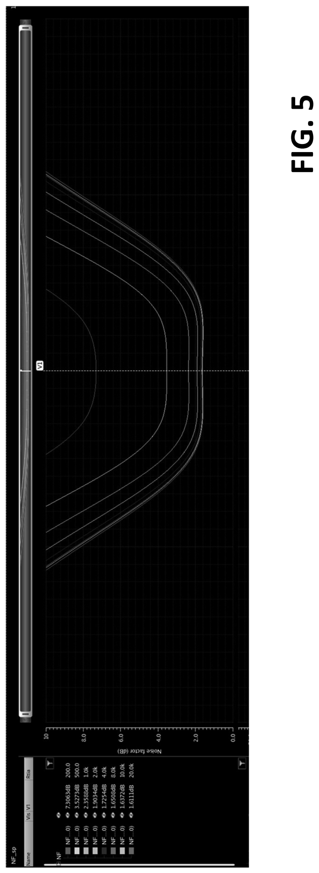

In contrast, FIG. 5 depicts the noise figure penalty for the same transfer functions for a staggered-voltage-mode 2-frequency N-path filter. In comparing the depictions of FIGs. 4 and 5, the noise figure of the voltage mode combination of N-path filters (e.g., approximately 1.8 dB at its lowest point) shows a lower noise figure than the current-mode counterpart (e.g., approximately 3.8 dB at its lowest point).

According to a second aspect, a wideband channel selective LNA front-end circuit can achieve good noise performance and high linearity in the presence of a large self-transmission blocker first by embedding a voltage-mode staggered 2-frequency N-path filter at the output of a broadband voltage amplifier. The N-path filters may be embedded in feedback to reduce the far out rejection of the individual N-path filters, in addition to reducing the area of the capacitors required to implement the same.

This wideband channel selective LNA front-end circuit can also achieve good noise performance and high linearity in the presence of a large self-TX blocker by subtracting the responses of the staggered 2-frequency N-path filters after passing them through voltage gain. This subtraction mitigates the various trade-offs involved in a current-mode implementation, as described above.

The LNA according to the second aspect exhibits wideband operation, low noise, high linearity in the presence of blockers, high channel-selectivity, and low area. The LNA according to the second aspect achieves these objectives at least by using a wideband inverter stage driving a multi-frequency staggered voltage-mode N-path-filter based channel-selective amplifier.

The LNA in FIG. 3 according to the first aspect, is a voltage-mode implementation of a staggered 2-frequency N-path filter, which addresses or remedies various trade-offs that exist in the current-mode amplifiers of FIGs. 1 and 2 in terms of noise, power, linearity and vastly differing gm requirements on different transistors in the cascode stack. While it can be shown that infinite far-out rejection is possible for multi-frequency staggered-N-path-filters while taking the output differentially ($V_{bpp}$ - $V_{bpn}$ or $V_x$ - $V_y$ in FIG. 3), the rejection is limited by the on-resistance of the mixer-switches $R_{on}$ at the single-ended nodes $v_x$ and $v_y$ respectively. In the absence of sufficient rejection by the mixer switches, while the system exhibits the desired higher-order small-signal filtering, the LNA suffers from worse linearity in the presence of blockers. Reducing the on resistance of mixer switches $R_{on}$ comes at the cost of the higher LO power required to drive the mixer switches and higher parasitic capacitances at the nodes $v_x$ and $v_y$.

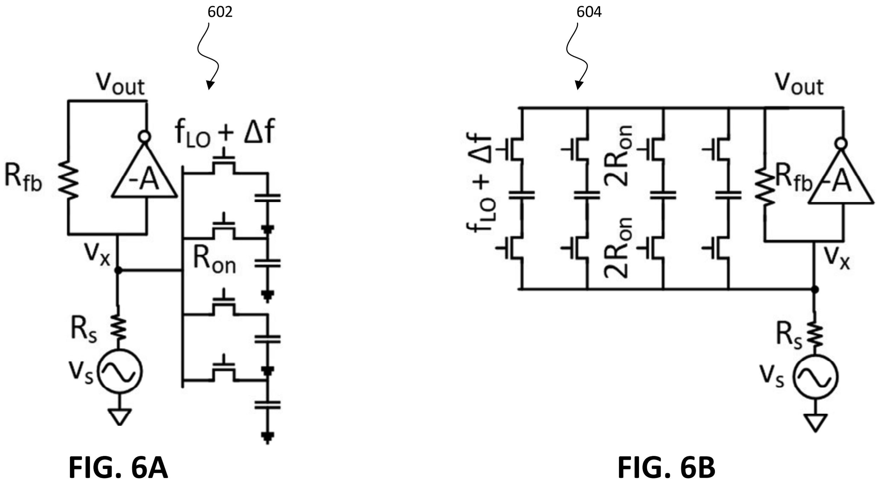

FIG 6A depicts an amplification stage with N-path filter 602 as depicted in FIG. 3. FIG. 6B depicts an amplification stage with N-path filter 604 according to the second aspect. For the amplification stage in FIG. 6A, it can be shown that the far-out rejection at the nodes $v_x/v_y$ is given by:

$$\frac{v_{x,y}}{v_s} = \frac{R_{on}}{R_{on} + \frac{R_{fb}}{1+A} \| R_s} \cdot \frac{\frac{R_{fb}}{1+A}}{\frac{R_{fb}}{1+A} + R_s} \tag{1}$$

Connecting the N-path filter in feedback as depicted in FIG. 6B provides a 2-fold benefit of boosting the capacitance and lowering the effective switch resistance $R_{on}$. However, to mitigate the impact of bottom-plate parasitics of the capacitor, two switches are connected in series and driven by the same clock phase. To maintain the same load to the LO chain driving the switches, and consequently same LO power, each switch must double the resistance (e.g., given by $2R_{on}$), thereby yielding a total of $4R_{on}$. However, when the switch is in feedback around the amplifier, the Miller effect improves the far-out rejection at the nodes $v_x/v_y$ to

$$\frac{v_{x,y}}{v_s} = \frac{\frac{4R_{on}}{1+A}}{\frac{4R_{on}}{1+A} + \frac{R_{fb}}{1+A} \| R_s} \cdot \frac{\frac{R_{fb}}{1+A}}{\frac{R_{fb}}{1+A} + R_s} \tag{2}$$

For a high feedback resistance $R_{fb}$, the far-out rejection is boosted by as much as $(1+A)/4$ for the same power consumption on both the signal path and the local oscillator path. Therefore, the blocker-swings at the nodes $v_x$ and $v_y$ are significantly lower than in the circuit in FIG. 6A.

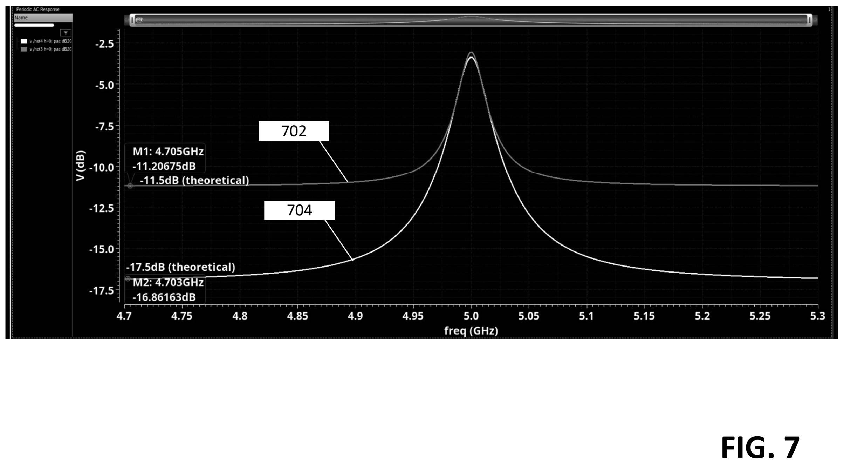

FIG. 7 depicts a simulation of the two N-path filters shown in FIGs. 6A and 6B. The simulation used the following component values: $R_S = 50$ohm, $R_{on} = 20$ohm, $R_{fb} = 2$kohm, and $A = 9$. The top curve (M1) 702 corresponds to the filter of FIG 6A (first aspect), and the bottom curve (M2) 704 corresponds to the filter of FIG. 6B (second aspect). It can be seen in FIG. 7 that the configuration of FIG. 6B yields a better filter response with greater reduction of far out frequencies as compared to that of the configuration of FIG. 6A.

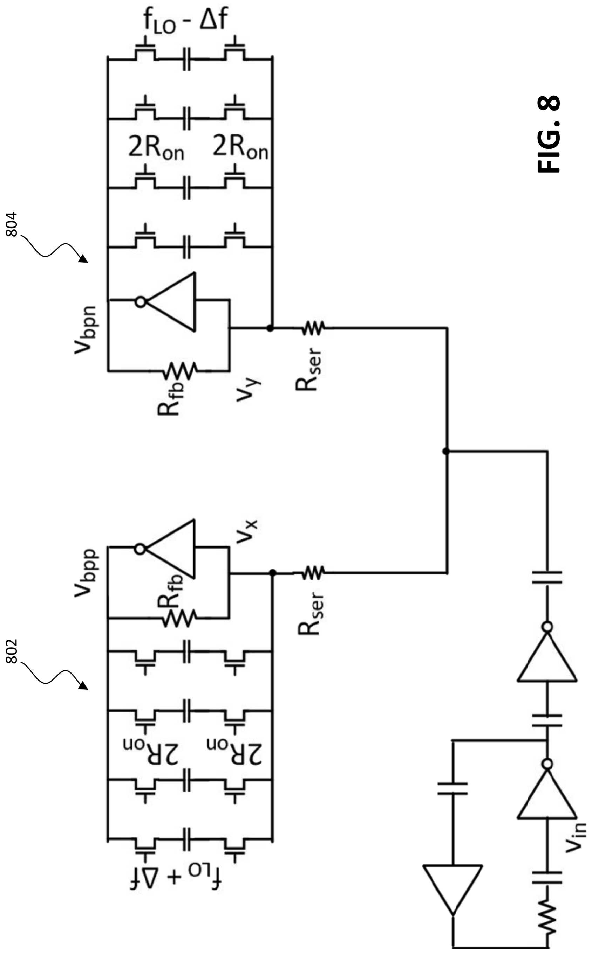

FIG. 8 depicts the circuit according to the second aspect in which a 2-frequency N-path filter is constructed using the circuit of FIG. 6B, which has the N-path filter in feedback around the LNA, as opposed to connecting it in shunt at the input. Specifically, the circuit of FIG. 8 includes a first N-path filter 802 in feedback around the first LNA and a second N-path filter 804 in feedback around the second LNA. The proposed circuit achieves the same second-order filtering as the circuit of FIG. 3, but by using a capacitor which can be as much as $(1+A)$ times lower, results in area savings compared to the circuit of FIG. 3. Additionally, input nodes $v_x$ and $v_y$ exhibit lower blocker swings due to the fact that the far-out rejection of the N-path filters is improved by the Miller effect. Consequently, the circuit of FIG. 8 exhibits better linearity in the presence of a blocker.

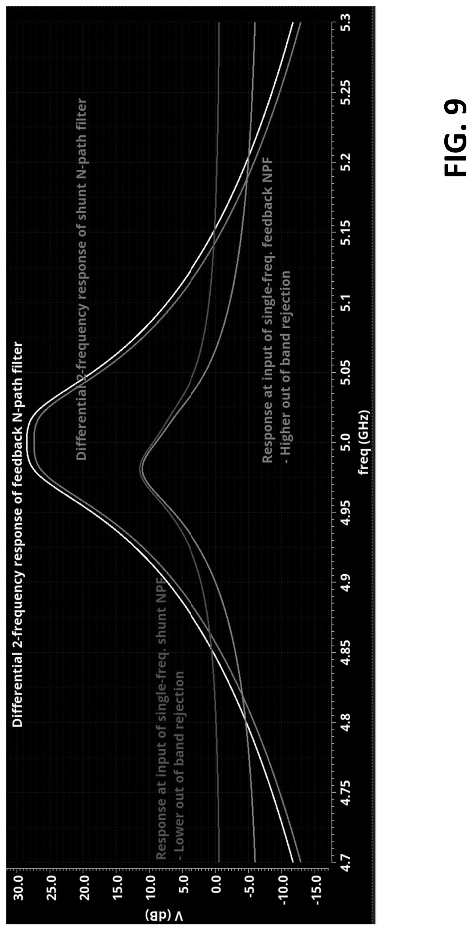

FIG. 9 depicts the benefits of the circuit of FIG. 8 (e.g., the circuit with a feedback N-path filter) as compared to the circuit of FIG. 3 (e.g., with a shunt N-path filter). In viewing the curves on the leftmost portion of FIG. 9, the top curve (e.g., at approximately 0 dB on the leftmost side of FIG. 9) depicts the response at the input of a single-frequency, shunt N-path filter. It can be seen that this exhibits less out-of-band rejection compared to the other curves on this figure. The second curve from the top (e.g., at approximately -6 dB on the leftmost side of FIG. 9) shows the response at the input of a single-frequency feedback N-path filter, which depicts a better out of band rejection than the first curve. The bottom two curves (e.g., at approximately -12 dB and -13 dB on the leftmost side of FIG. 9) depict the differential frequency response of the shunt N-path filter.

While the small-signal differential output response of the 2-frequency N-path filter is approximately the same for both the circuits, the blocker attenuation is higher at the nodes $v_x$ and $v_y$ for the feedback N-path filter. Consequently, the amplifier suffers from lesser non-linearity. For context, the simulation of FIG. 9 assumed ideal components, wherein the input stage is replaced by an ideal $g_m$ with an output resistance of 50-ohm. The following component values were used: $R_{ser} = 100$ohm, $R_{on} = 20$ohm, $R_{fb} = 2$kohm, $A = 9$. The capacitance was chosen for identical bandwidths, with a smaller capacitor required for the feedback N-path filter.

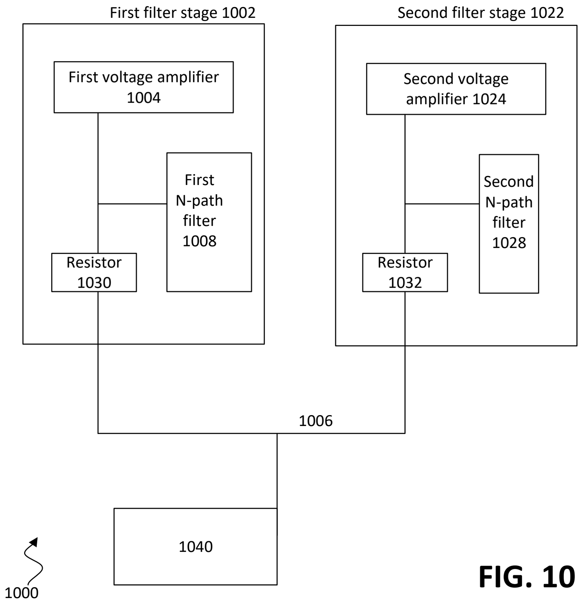

FIG. 10 depicts a voltage-mode amplifier 1000, including a first filter stage 1002, including: a first voltage amplifier 1004, connected to an input trace 1006, and configured to amplify a signal conducted along the input trace 1006; and a first N-path filter 1008, connected to the input trace 1006; wherein the first N-path filter 1008 is configured to shunt a first reference voltage frequency from the signal; and a second filter stage 1022, connected to the input trace 1006 in parallel to the first filter stage 1002, including a second voltage amplifier 1024, connected to the input trace 1006, and configured to amplify the signal conducted along the input trace 1006; and a second N-path filter 1028, connected to the input trace 1006; and wherein the second N-path filter 1028 is configured to shunt a second reference voltage frequency from the signal. The first reference voltage frequency may be an offset greater than an operating frequency, and the second reference voltage frequency may be the offset less than the operating frequency.

The voltage-mode amplifier 1000 may further include a first ohmic resistor 1030, wherein the first N-path filter 1008 is connected to the input trace 1006 between the first voltage amplifier 1004 and the first ohmic resistor 1030. The voltage-mode amplifier 1000 may further include a second ohmic resistor 1032, wherein the second N-path filter 1028 is connected to the input trace 1006 between the second voltage amplifier 1024 and the second ohmic resistor 1032.

The voltage-mode amplifier may further include a combining stage (not depicted), which may be configured to subtract an output of one of the first filter stage or the second filter stage from an ouput of another of the first filter stage or the second filter stage. The first N-path filter may include a plurality of first switches (not depicted) that each has a first switch input and a first switch output. The input trace may be connected in parallel to each first switch input. Each first switch output may connected to a capacitor and a reference voltage. The second N-path filter may include a plurality of second switches. Each switch of the plurality of second switches may include a second switch input and a second switch output. The input trace may be connected in parallel to each second switch input, and each second switch output may be connected to a capacitor and a reference voltage. The voltage-mode amplifier may include an N-path filter controller, which may be configured to control the plurality of first switches to sequentially close and open according to a first filter frequency that is an offset greater than the operating frequency and/or to control the plurality of second switches to sequentially close and open according to a second filter frequency that is an offset less than the operating frequency.

The first voltage amplifier may be configured as an inverting operational amplifier, and the second voltage amplifier may be configured as an inverting operational amplifier.

The voltage-mode amplifier may further include a primary voltage amplifier 1040, which may be configured to receive an input and to generate the signal by amplifying the input. The primary voltage amplifier 1040 may be configured to output the signal to the input trace.

In an alternative configuration, the voltage-mode amplifier of FIG. 10 may be configured consistently with that of FIG. 6B or FIG. 8, wherein the first filter stage includes a first voltage amplifier that is connected to an input trace, and configured to amplify a signal conducted along the input trace; and a first N-path filter, which is connected to the input trace and to an output of the first voltage amplifier. In this manner, the first N-path filter is connected in feedback to the first voltage amplifier. Similarly, and in this alternative configuration, the second filter stage may be connected to the input trace in parallel to the first filter stage and may include a second voltage amplifier, which is connected to the input trace and configured to amplify the signal conducted along the input trace; and a second N-path filter, which is connected to the input trace and to an output of the second voltage amplifier.

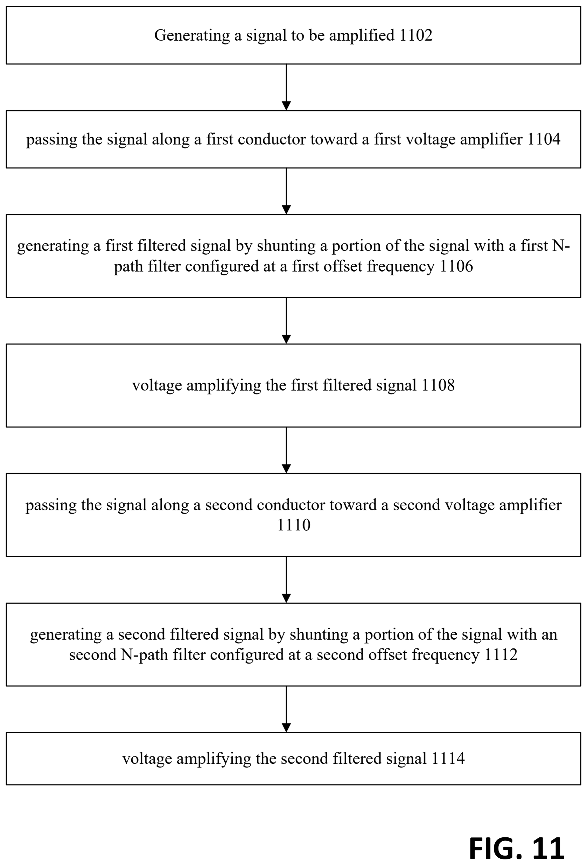

FIG. 11 depicts a method of voltage amplification, including generating a signal to be amplified 1102; passing the signal along a first conductor toward a first voltage amplifier 1104; generating a first filtered signal by shunting a portion of the signal with a first N-path filter configured at a first offset frequency 1106; voltage amplifying the first filtered signal 1108; passing the signal along a second conductor toward a second voltage amplifier 1110; generating a second filtered signal by shunting a portion of the signal with an second N-path filter configured at a second offset frequency 1112; and voltage amplifying the second filtered signal 1114. In this manner, the first offset frequency may be an offset greater than an operating frequency, and the second offset frequency may be the offset less than the operating frequency. The method may further include subtracting one of the amplified first filtered signal or the amplified second filter signal from an output of another of the amplified first filtered signal or the amplified second filter signal.

Further aspects will be provided by way of example.

In Example 1, a voltage-mode amplifier, including: a first filter stage, including: a first voltage amplifier, connected to an input trace, and configured to amplify a signal conducted along the input trace; and a first N-path filter, connected to the input trace; wherein the first N-path filter is configured to shunt to a first reference voltage frequency from the signal; and a second filter stage, connected to the input trace in parallel to the first filter stage, including: a second voltage amplifier, connected to the input trace, and configured to amplify the signal conducted along the input trace; and a second N-path filter, connected to the input trace; and wherein the second N-path filter is configured to shunt to a second reference voltage frequency from the signal.

In Example 2, the voltage-mode amplifier of Example 1, wherein the first reference voltage frequency is an offset greater than an operating frequency, and wherein the second reference voltage frequency is an offset less than the operating frequency.

In Example 3, the voltage-mode amplifier of Example 1 or 2, further including: a first ohmic resistor, wherein the first N-path filter is connected to the input trace between the first voltage amplifier and the first ohmic resistor; and a second ohmic resistor, wherein the second N-path filter is connected to the input trace between the second voltage amplifier and the second ohmic resistor.

In Example 4, the voltage-mode amplifier of any one of Examples 1 to 3, further including a combining stage, configured to subtract an output of one of the first filter stage or the second filter stage from an output of another of the first filter stage or the second filter stage.

In Example 5, the voltage-mode amplifier of any one of Examples 2 to 4, wherein the first N-path filter includes a plurality of first switches, each switch of a plurality of first switches including a first switch input and a first switch output; wherein the input trace is connected in parallel to each first switch input and wherein each first switch output is connected to a capacitor and a reference voltage; wherein the second N-path filter includes a plurality of second switches, each switch of a plurality of second switches including a second switch input and a second switch output; and wherein the input trace is connected in parallel to each second switch input, and wherein each second switch output is connected to a capacitor and a reference voltage.

In Example 6, the voltage-mode amplifier of Example 5, further including an N-path filter controller, configured to control the plurality of first switches to sequentially close and open according to a first filter frequency that is an offset greater than the operating frequency.

In Example 7, the voltage-mode amplifier of Example 5 or 6, wherein the N-path filter controller is further configured to control the plurality of second switches to sequentially close and open according to a second filter frequency that is an offset less than the operating frequency.

In Example 8, the voltage-mode amplifier of any one of Examples 1 to 7, wherein the first voltage amplifier is configured as an inverting operational amplifier, and wherein the second voltage amplifier is configured as an inverting operational amplifier.

In Example 9, the voltage-mode amplifier of any one of Examples 1 to 8, further including a primary voltage amplifier, configured to receive an input and to generate the signal by amplifying the input; and wherein the primary voltage amplifier is configured to output the signal to the input trace.

In Example 10, a voltage-mode amplifier, including: a first filter stage, including: a first voltage amplifier, connected to an input trace, and configured to amplify a signal conducted along the input trace; and a first N-path filter, connected to the input trace and to an output of the first voltage amplifier; a second filter stage, connected to the input trace in parallel to the first filter stage, including: a second voltage amplifier, connected to the input trace, and configured to amplify the signal conducted along the input trace; and a second N-path filter, connected to the input trace and to an output of the second voltage amplifier.

In Example 11, the voltage-mode amplifier of Example 10, further including, a first ohmic resistor, connected along the input trace in serial to the first voltage amplifier, wherein the first N-path filter is connected to the input trace between the first voltage amplifier and the first ohmic resistor; and a second ohmic resistor, connected along the input trace in serial to the second voltage amplifier, wherein the second N-path filter is connected to the input trace between the second voltage amplifier and the second ohmic resistor.

In Example 12, the voltage-mode amplifier of Example 10 or 11, wherein the first N-path filter includes a plurality of first filter paths in parallel to one another; wherein each first filter path includes a capacitor between two first switches; wherein the second N-path filter includes a plurality of second filter paths in parallel to one another; and wherein each second filter path includes a capacitor between two second switches.

In Example 13, the voltage-mode amplifier of any one of Examples 10 to 12, further including a combining stage, configured to subtract an output of one of the first filter stage or the second filter stage from an output of another of the first filter stage or the second filter stage.

In Example 14, the voltage-mode amplifier of Example 13, further including an N-path filter controller, configured to control the plurality of first switches to sequentially close and open according to a first filter frequency that is an offset greater than an operating frequency.

In Example 15, the voltage-mode amplifier of Example 13 or 14, further including an N-path filter controller, configured to control the plurality of second switches to sequentially close and open according to a second filter frequency that is an offset less than an operating frequency.

In Example 16, the voltage-mode amplifier of any one of Examples 10 to 15, further including a primary voltage amplifier, configured to receive an input and to generate the signal by amplifying the input; and wherein the primary voltage amplifier is configured to output the signal to the input trace.

In Example 17, the voltage-mode amplifier of Example 10 or 16, wherein the first voltage amplifier is configured as an inverting operational amplifier, and wherein the second voltage amplifier is configured as an inverting operational amplifier.

In Example 18, a voltage-mode amplifier, including: a first filter stage, including: a first voltage amplifier for amplifying a signal conducted along the input trace; and a first N-path filter, connected to the input trace; wherein the first N-path filter is for shunting a first reference voltage frequency from the signal; and a second filter stage, connected to the input trace in parallel to the first filter stage, including: a second voltage amplifier, connected to the input trace, and for amplifying the signal conducted along the input trace; and a second N-path filter, connected to the input trace; and wherein the second N-path filter is for shunting to a second reference voltage frequency from the signal.

In Example 19, the voltage-mode amplifier of Example 18, wherein the first reference voltage frequency is an offset greater than an operating frequency, and wherein the second reference voltage frequency is an offset less than the operating frequency.

In Example 20, the voltage-mode amplifier of Example 18 or 19, further including: a first ohmic resistor, wherein the first N-path filter is connected to the input trace between the first voltage amplifier and the first ohmic resistor; and a second ohmic resistor, wherein the second N-path filter is connected to the input trace between the second voltage amplifier and the second ohmic resistor.

In Example 21, the voltage-mode amplifier of any one of Examples 18 to 20, further including a combining stage for subtracting an output of one of the first filter stage or the second filter stage from an output of another of the first filter stage or the second filter stage.

In Example 22, the voltage-mode amplifier of any one of Examples 19 to 21, wherein the first N-path filter includes a plurality of first switches, each switch of a plurality of first switches including a first switch input and a first switch output; wherein the input trace is connected in parallel to each first switch input and wherein each first switch output is connected to a capacitor and a reference voltage; wherein the second N-path filter includes a plurality of second switches, each switch of a plurality of second switches including a second switch input and a second switch output; and wherein the input trace is connected in parallel to each second switch input, and wherein each second switch output is connected to a capacitor and a reference voltage.

In Example 23, the voltage-mode amplifier of Example 22, further including an N-path filter controller for controlling the plurality of first switches to sequentially close and open according to a first filter frequency that is an offset greater than the operating frequency.

In Example 24, the voltage-mode amplifier of Example 22 or 23, wherein the N-path filter controller is further for controlling the plurality of second switches to sequentially close and open according to a second filter frequency that is an offset less than the operating frequency.

In Example 25, the voltage-mode amplifier of any one of Examples 18 to 24, wherein the first voltage amplifier is an inverting operational amplifier, and wherein the second voltage amplifier is an inverting operational amplifier.

In Example 26, the voltage-mode amplifier of any one of Examples 18 to 25, further including a primary voltage amplifier for receiving an input and to generate the signal by amplifying the input; and wherein the primary voltage amplifier is for outputting the signal to the input trace.

In Example 27, a voltage-mode amplifier, including: a first filter stage, including: a first voltage amplifier, connected to an input trace, and for amplifying a signal conducted along the input trace; and a first N-path filter, connected to the input trace and to an output of the first voltage amplifier; a second filter stage, connected to the input trace in parallel to the first filter stage, including: a second voltage amplifier, connected to the input trace, for amplifying the signal conducted along the input trace; and a second N-path filter, connected to the input trace and to an output of the second voltage amplifier.

In Example 28, the voltage-mode amplifier of Example 27, further including, a first ohmic resistor, connected along the input trace in serial to the first voltage amplifier, wherein the first N-path filter is connected to the input trace between the first voltage amplifier and the first ohmic resistor; and a second ohmic resistor, connected along the input trace in serial to the second voltage amplifier, wherein the second N-path filter is connected to the input trace between the second voltage amplifier and the second ohmic resistor.

In Example 29, the voltage-mode amplifier of Example 27 or 28, wherein the first N-path filter includes a plurality of first filter paths in parallel to one another; wherein each first filter path includes a capacitor between two first switches; wherein the second N-path filter includes a plurality of second filter paths in parallel to one another; and wherein each second filter path includes a capacitor between two second switches.

In Example 30, the voltage-mode amplifier of any one of Examples 27 to 29, further including a combining stage, configured to subtract an output of one of the first filter stage or the second filter stage from an output of another of the first filter stage or the second filter stage.

In Example 31, the voltage-mode amplifier of Example 30, further including an N-path filter controller for controlling the plurality of first switches to sequentially close and open according to a first filter frequency that is an offset greater than an operating frequency.

In Example 32, the voltage-mode amplifier of Example 30 or 31, further including an N-path filter controller for controlling the plurality of second switches to sequentially close and open according to a second filter frequency that is an offset less than an operating frequency.

In Example 33, the voltage-mode amplifier of any one of Examples 27 to 32, further including a primary voltage amplifier for receiving an input and to generate the signal by amplifying the input; and wherein the primary voltage amplifier is for outputting the signal to the input trace.

In Example 34, the voltage-mode amplifier of Example 27 or 33, wherein the first voltage amplifier is configured as an inverting operational amplifier, and wherein the second voltage amplifier is configured as an inverting operational amplifier.

In Example 35, a method of voltage amplification, including: generating a signal to be amplified; passing the signal along a first conductor toward a first voltage amplifier; generating a first filtered signal by shunting a portion of the signal with a first N-path filter configured at a first offset frequency; and voltage amplifying the first filtered signal; and passing the signal along a second conductor toward a second voltage amplifier; generating a second filtered signal by shunting a portion of the signal with an second N-path filter configured at a second offset frequency; and a voltage amplifying the second filtered signal.

In Example 36, the method of Example 35, wherein the first offset frequency is an offset greater than an operating frequency, and wherein the second offset frequency is an offset less than the operating frequency.

In Example 37, the method of any one of Examples 35 to 36, further including subtracting one of the amplified first filtered signal or the amplified second filter signal from an output of another of the amplified first filtered signal or the amplified second filter signal.

In Example 38, a non-transitory computer readable medium, including instructions which, if executed by a processor, cause the processor to generate a signal to be amplified; control a circuit to pass the signal along a first conductor toward a first voltage amplifier; control the circuit to generate a first filtered signal by shunting a portion of the signal with a first N-path filter configured at a first offset frequency; and control the circuit to amplify a voltage of the first filtered signal; and control the circuit to pass the signal along a second conductor toward a second voltage amplifier; control the circuit to generate a second filtered signal by shunting a portion of the signal with an second N-path filter configured at a second offset frequency; and control the circuit to amplify a voltage of the second filtered signal.

In Example 39, the non-transitory computer readable medium of Example 38, wherein the first offset frequency is an offset greater than an operating frequency, and wherein the second offset frequency is an offset less than the operating frequency.

While the above descriptions and connected figures may depict components as separate elements, skilled persons will appreciate the various possibilities to combine or integrate discrete elements into a single element. Such may include combining two or more circuits for form a single circuit, mounting two or more circuits onto a common chip or chassis to form an integrated element, executing discrete software components on a common processor core, etc. Conversely, skilled persons will recognize the possibility to separate a single element into two or more discrete elements, such as splitting a single circuit into two or more separate circuits, separating a chip or chassis into discrete elements originally provided thereon, separating a software component into two or more sections and executing each on a separate processor core, etc.

It is appreciated that implementations of methods detailed herein are demonstrative in nature, and are thus understood as capable of being implemented in a corresponding device. Likewise, it is appreciated that implementations of devices detailed herein are understood as capable of being implemented as a corresponding method. It is thus understood that a device corresponding to a method detailed herein may include one or more components configured to perform each aspect of the related method.

All acronyms defined in the above description additionally hold in all claims included herein.

## Claims

1. An apparatus, comprising:

   a first filter stage, comprising:

   a first voltage amplifier, coupled to an input trace, and configured to amplify a signal conducted along the input trace; and
   a first N-path filter, coupled to the input trace and to an output of the first voltage amplifier;

   a second filter stage, coupled to the input trace in parallel to the first filter stage, comprising:

   a second voltage amplifier, coupled to the input trace, and configured to amplify the signal conducted along the input trace; and
   a second N-path filter, coupled to the input trace and to an output of the second voltage amplifier.

2. The voltage-mode amplifier of claim 1, further comprising:
   a first ohmic resistor, coupled along the input trace in serial to the first voltage amplifier, wherein the first N-path filter is coupled to the input trace between the first voltage amplifier and the first ohmic resistor; and a second ohmic resistor, coupled along the input trace in serial to the second voltage amplifier, wherein the second N-path filter is coupled to the input trace between the second voltage amplifier and the second ohmic resistor.

3. The apparatus of any one of claims 1 or 2,
   wherein the first N-path filter comprises a plurality of first filter paths in parallel to one another; wherein each first filter path comprises a capacitor coupled between two first switches; wherein the second N-path filter comprises a plurality of second filter paths in parallel to one another; and wherein each second filter path comprises a capacitor coupled between two second switches.

**4.** The apparatus of any one of claims 1 to 3, further comprising:
a combining stage, configured to subtract an output of one of the first filter stage or the second filter stage from an output of another of the first filter stage or the second filter stage.

**5.** The apparatus of claim 4, further comprising
an N-path filter controller, configured to control the plurality of first switches to sequentially close and open according to a first filter frequency that is an offset greater than an operating frequency.

**6.** The apparatus of any one of claims 4 or 5, further comprising
an N-path filter controller, configured to control the plurality of second switches to sequentially close and open according to a second filter frequency that is an offset less than an operating frequency.

**7.** The apparatus of any one of claims 1 to 6, further comprising:
a primary voltage amplifier, configured to receive an input and to generate the signal by amplifying the input; and
wherein the primary voltage amplifier is configured to output the signal to the input trace.

**8.** The apparatus of any one of claims 1 to 7,
wherein the first voltage amplifier is configured as an inverting operational amplifier, and wherein the second voltage amplifier is configured as an inverting operational amplifier.

**9.** The apparatus of any one of claims 1 to 8,
wherein the apparatus is provided in at least one of an integrated circuit, a System on Chip, a System in Package or a computing device.

**10.** A method of voltage amplification, comprising:

generating a signal to be amplified;
passing the signal along a first conductor toward a first voltage amplifier;
generating a first filtered signal by shunting a portion of the signal with a first N-path filter configured at a first offset frequency; and
voltage amplifying the first filtered signal; and
passing the signal along a second conductor toward a second voltage amplifier;
generating a second filtered signal by shunting a portion of the signal with an second N-path filter configured at a second offset frequency; and
a voltage amplifying the second filtered signal.

**11.** The method of claim 10,
wherein the first offset frequency is an offset greater than an operating frequency, and wherein the second offset frequency is an offset less than the operating frequency.

**12.** The method of any one of claims 10 or 11, further comprising:
subtracting one of the amplified first filtered signal or the amplified second filter signal from an output of another of the amplified first filtered signal or the amplified second filter signal.

**13.** A a non-transitory computer readable medium, including instructions which, if executed by a processor, cause the processor to implement a method of voltage amplification of any one of claims 10 to 12.

FIG. 1

FIG. 2

FIG. 3

FIG. 4

FIG. 5

**FIG. 6B**

**FIG. 6A**

**FIG. 7**

702

704

M1: 4.705GHz
-11.20675dB
-11.5dB (theoretical)

-17.5dB (theoretical)
M2: 4.703GHz
-16.86163dB

Periodic AC Response

V (dB)

freq (GHz)

FIG. 8

EP 4 761 106 A1

FIG. 9

First filter stage 1002

First voltage amplifier
1004

First
N-path
filter
1008

Resistor
1030

Second filter stage 1022

Second voltage
amplifier 1024

Second
N-path
filter
1028

Resistor
1032

1006

1040

1000

**FIG. 10**

Generating a signal to be amplified 1102

↓

passing the signal along a first conductor toward a first voltage amplifier 1104

↓

generating a first filtered signal by shunting a portion of the signal with a first N-path filter configured at a first offset frequency 1106

↓

voltage amplifying the first filtered signal 1108

↓

passing the signal along a second conductor toward a second voltage amplifier 1110

↓

generating a second filtered signal by shunting a portion of the signal with an second N-path filter configured at a second offset frequency 1112

↓

voltage amplifying the second filtered signal 1114

**FIG. 11**

Europäisches
Patentamt

European
Patent Office

Office européen
des brevets

# EUROPEAN SEARCH REPORT

**Application Number**

EP 25 20 7992

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2019/334504 A1 (PARK JOUNG WON [US] ET AL) 31 October 2019 (2019-10-31) | 1-3, 7-11,13 | INV. H03F3/193 |
| A | * paragraphs [0046], [0059], [0092] - [0094]; figures 4,7,9,11 * | 4-6,12 | H03F3/45 H03F3/68 |
| A | EP 4 333 295 A1 (INTEL CORP [US]) 6 March 2024 (2024-03-06) * abstract; figure 9 * | 1-13 | |
| A | KLEINE U ET AL: "Low-voltage medium Q-SC filters for high frequency communication applications", ELECTRONICS, CIRCUITS AND SYSTEMS, 1998 IEEE INTERNATIONAL CONFERENCE ON LISBOA, PORTUGAL 7-10 SEPT. 1998, PISCATAWAY, NJ, USA,IEEE, US, vol. 2, 7 September 1998 (1998-09-07), pages 39-42, XP010366338, DOI: 10.1109/ICECS.1998.814818 ISBN: 978-0-7803-5008-3 * abstract; figure 2 * | 1-13 | |
| | | | TECHNICAL FIELDS SEARCHED (IPC) |
| A | US 9 374 063 B1 (MAK PUI-IN [CN] ET AL) 21 June 2016 (2016-06-21) * paragraphs [0029] - [0038]; figures 2A,2B * | 1-13 | H03F |

The present search report has been drawn up for all claims

| Place of search | Date of completion of the search | Examiner |
|---|---|---|
| The Hague | 2 March 2026 | Zakharian, Andre |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 20 7992

This annex lists the patent family members relating to the patent documents cited in the above-mentioned European search report.
The members are as contained in the European Patent Office EDP file on
The European Patent Office is in no way liable for these particulars which are merely given for the purpose of information.

02-03-2026

| Patent document cited in search report | | Publication date | Patent family member(s) | | Publication date |
|---|---|---|---|---|---|
| US 2019334504 | A1 | 31-10-2019 | CN | 112042121 A | 04-12-2020 |
| | | | EP | 3785371 A2 | 03-03-2021 |
| | | | US | 2019334504 A1 | 31-10-2019 |
| | | | WO | 2019209728 A2 | 31-10-2019 |
| EP 4333295 | A1 | 06-03-2024 | EP | 4333295 A1 | 06-03-2024 |
| | | | US | 2024056120 A1 | 15-02-2024 |
| US 9374063 | B1 | 21-06-2016 | US | 9374063 B1 | 21-06-2016 |
| | | | US | 2016233848 A1 | 11-08-2016 |
| | | | US | 2016233906 A1 | 11-08-2016 |
| | | | US | 2016233908 A1 | 11-08-2016 |

EPO FORM P0459

For more details about this annex : see Official Journal of the European Patent Office, No. 12/82